# EUROPEAN PATENT SPECIFICATION

(11) **EP 0 327 399 B1**
(45) Date of publication and mention of the grant of the patent: **17.04.1996**
(21) Application number: 89301106.4
(22) Date of filing: 03.02.1989
(51) Int. Cl.: H01L 21/48, H01L 23/50

(54) **Method of manufacturing an uniaxially electrically conductive article**
Verfahren zum Herstellen eines uniaxial elektrisch leitenden Artikels
Procédé de fabrication d'un article électroconducteur uni-axial

(30) Priority: 05.02.1988 GB 8802567; 05.02.1988 GB 8802565; 29.06.1988 GB 8815447; 30.09.1988 GB 8823053; 02.12.1988 GB 8828245
(43) Date of publication of application: 09.08.1989
(73) Proprietor: RAYCHEM LIMITED, London, EC4 1NL (GB)
(72) Inventor: Ludden, Michael Joseph, Coventry, CD4 8EW (GB); Smith, Nicholas J. G., Cricklade Wiltshire, SN6 6LT (GB); Gibney, Paul James, Swindon Wiltshire, SN3 6NW (GB); Nyholm, Peter, Swindon Wiltshire, SN1 4JY (GB)
(74) Representative: Jay, Anthony William

(56) References cited:
- EP-A- 0 171 232
- EP-A- 0 183 598
- EP-A- 0 213 774
- EP-A- 0 213 774
- EP-A- 0 245 179
- EP-A- 0 245 179
- EP-A- 0 260 490
- WO-A-87/04316
- US-A- 4 667 219

## Description

This invention relates to a method of manufacturing an uniaxially electrically conductive article.

It is known from U.S. Patent No. 3303085 to produce porous mica sheets in which relatively straight-line through-holes of 5 to 20,000 Angstroms (10 Angstroms ≙ 1nm) diameter, produced by heavy particle radiation followed by etching of the mica, are simply filled with superconductive material or iron particles to provide oriented single domain ferromagnetic sheet, or with material suitable for imaging in television cameras. The surfaces of the mica sheet may be polished or abraded to assure electrical contact with the conductive filler.

Porous polymer sheets in which selected areas of the interconnecting through-holes are masked and the unmasked through-holes are metal plated to provide electrically conductive spots surrounded by insulating areas, are known from Japanese Published Patent Application 80161306.

Published EP-A-0213774 describes a superior form of uniaxially electrically conductive article comprising porous electrically insulating sheet material at least a selected portion of which has at least 25 substantially non-interconnected through-holes of not more than 200 micrometres diameter per square millimetre of its surface, at least a significant proportion of which through-holes individually contain in tubular formations electrically conductive material which provides an electrically conductive path between, and projects beyond at least one of, the main surfaces of the sheet material, each such conductive path being electrically separate from substantially all of the other such conductive paths. The tubular formations may comprise a first portion of electrically conductive material and a second portion of electrically conductive material on at least one of the end surfaces of the first portion, at least the parts of the second portion on one or both of the end surfaces of the first portion projecting beyond the sheet surface(s).

EP-A-0 245 179 describes a resilient anisotropic conductor pad for use in a semiconductor mounting system, the pad comprising an elastomeric matrix having a plurality of discrete conductive elements embedded therein. The conductive elements may be copper, aluminium, silver, gold or alloys thereof.

EP-A-0 171 232 describes a flexible tape for bonding electronic components to external circuitry. The tape is prepared by forming openings or vias of a described pattern in a dielectric material, applying a layer of conductive material over all the tape and selectively removing the conductive material to leave terminals 10, 11 in the openings and conductive traces selectively interconnecting the terminals.

EP-A-0 260 490 describes a bonding sheet for bonding to an electronic component. The bonding sheet comprises a tape of insulating material having a predetermined number of through-holes at positions corresponding to electrode terminals of a semiconductor element. A layer of bonding metal is applied to the tape and the metal caused to fill the holes in the tape. Parts of the metal layer are then removed to leave metal in and around the holes in the tape.

The present invention provides a method of manufacturing an uniaxially conductive article comprising electrically insulating sheet material with through-holes, the method including forming plated metal electrical conductors contained individually in the through-holes and having ends projecting from the sheet material, and forming a plating of a further layer of metal on the projecting ends, which plating acts as a collar to help retain each plated metal conductor in the respective through-hole, each conductor providing an electrically conductive path between the main surfaces of the sheet material.

The plating of the electrically conductive material in the through-holes is advantageous in enabling finer conductors (e.g. in holes of not more than 200 micrometres, for example 5 to 150, preferably 10 to 100 micrometres, diameter, less than 100 micrometres being generally preferred) to be positioned more accurately and efficiently than may be possible with other techniques. Precision is especially important with the increasing miniaturisation of electronic devices, for example when at least some of the said through-holes in the said pattern are less than 100 micrometres apart from centre to centre, in which case the through-holes will of course be less than 100 micrometres in diameter. Subject to such limitations imposed by the desired hole spacing, the through-holes in all aspects of the invention may for example be 1 to 200 micrometres in diameter, and it is also preferable in most cases that the conductive material project beyond both main surfaces of the sheet material, the projections from either surface preferably being, for example, 0.2 to 100 micrometres in height, preferably 0.5 to 30 micrometres, especially 2 to 25 micrometres.

The insulating sheet material will preferably be a flexible polymeric material, although inorganics could be used.

The metal conductors are plated, especially electrolessly plated, on the interior surface of the through-holes. Any suitably applicable metals may be used, for example Ni, Cu, Au, Co, Pd, Pd-Ni, Sn, Pb, Pb-Sn, In.

In preferred forms of the articles manufactured by a method according to this invention, the through-holes individually contain a tubular formation of the electrically conductive material projecting beyond the sheet surface. The term "tubular" is not intended to imply any specific cross-sectional shape: the holes may be circular, eliptical, polygonal, or any other convenient shape, and may be tapered or straight-sided.

Preferably, the plating of the further layer of metal is on the interior surfaces as well as the external surfaces of the projecting ends of the plated conductor. The plated metal electrical conductors are preferably electrolessly plated on the interior pore surface, and the further layer of metal is preferably electrolessly plated on the projecting ends. The plated metal electrical conductors and the further layer of metal may comprise different electrically conductive materials, and the further layer may fill the tubular plated conductor or may itself be tubular, in which case it may be filled with further electrically conductive (or other) material. Where the metal-lined through-holes are filled with another metal this will preferably be a solder, a low-melting-point metal, fusible alloy, or plated metal. The metal fillings may project beyond the sheet surface(s), and the other criteria mentioned above may apply as appropriate.

Preferably, electrically insulating material is removed from one or both surfaces of the sheet material to expose portions of the electrically conductive material originally within the through-holes, thus producing or increasing the desired projections of the conductive material beyond the sheet surface(s). This may be done by any convenient means, for example by dissolving away a surface layer of the sheet material, for which purpose a sheet having surface layers of material more readily soluble in a selected solvent than the underlying layers may be used.

Any electrically insulating sheet material may be used in which the required pattern of the through-holes can be formed with sufficient precision, preferred polymeric materials including those acceptable to the electronics industry, for example epoxies, polyurethanes, polyimides, silicone rubbers, polysulphones and polycarbonates. The sheet may carry an adhesive layer on one or both sides of its surfaces if desired for its intended end use. The preferred polyimide is one which is capable of retaining at least 50%, preferably at least 75%, more preferably at least 85%, of its original elongation after immersion in water of pH10 at 100°C for four days according to ATSM D882. It will be readily understood that a sufficiently fully cyclised polyimide having less than 15%, preferably less than 10%, more preferably less than 5%, and if possible, substantially no open imide rings or uncyclised amic acid groupings may be better able to survive hot alkaline metal plating baths, which attack incompletely cyclised polyimides such as Kapton (TM). Preferred materials include polyimides derived from polymerisation of 4,4'-biphenyl dianhydride and (4,4'-diaminobiphenyl, or 4,4'-diaminobiphenylether or phenylenediamine). The polyimide of 4,4'-diamobiphenyl may provide thermal characteristics which are especially well suited to microcircuit applications. Corresponding polymers using the 4,3'- or 3,3'-isomers of the above three diamines and/or using pyromellitic dianhydride instead of the biphenyldianhydride (but excluding Kapton, of course) may also be useful. The currently more preferred commercially available polyimides are those available under the Trade Mark "UPILEX" from Ube/ICI. One of these, "UPILEX R", is believed to be a relatively completely cyclised polymer having a repeat unit derived from biphenyl dianhydride and diaminodiphenylether, viz.

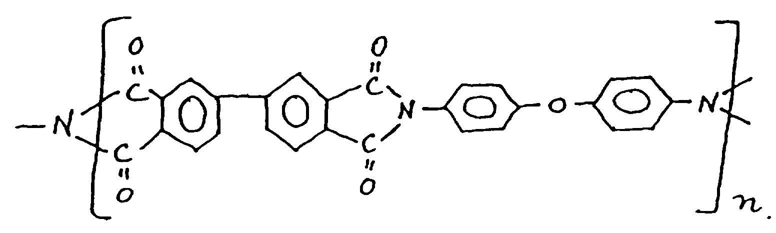

Most preferred, however, is "UPILEX S", which is believed to have a repeat unit derived from the same anhydride and p-phenylene diamine, viz.

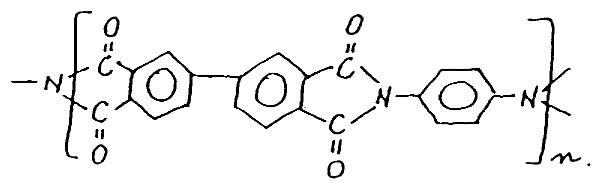

Sheet material for producing the uniaxially electrically conductive articles manufactured according to the invention may be produced by any convenient method. For example, any method that lends itself to piercing a suitable number of holes in dielectrics can be used. A non-exhaustive list of means to produce pierced sheets is given below:
1 Nuclear track etching: The polymeric sheet is exposed, through a mask corresponding to the desired pattern of through-holes, to high energy bombardment, either from a nuclear reactor or a high energy particle accelerator, and afterwards etched in a suitable solution. The damage tracks formed by the ions then show up as tubular through-holes in the sheet. Tubular through-holes with a hole diameter of 0.1 to 50 micrometres are easily drilled through 5 to 1000 micrometre sheets of e.g. polycarbonate or polyimide.
2 Laser drilling: The polymeric sheet is masked and subject to overall ablation of the exposed areas by laser light of low wavelength (350 to 150 nanometres). Any patterned screen limiting the laser light (e.g. a pierced metal screen) will give rise to the same pattern being reproduced on the polymeric sheet. Tubular through-holes greater than 5 micrometres in diameter can be produced by this method, and piercing through 0.5 millimetre thick layers is possible by extended exposure of e.g. epoxy, polyurethane, polymide, or polysulphide sheets. Alternatively, a focussed laser beam of any suitable wavelength could be used to drill individual holes.
   Laser drilling, preferably by ablative photodecomposition using a U.V. excimer laser e.g. KrF (249nm) or Xecl (308nm), has the advantage of producing through-holes with less pronounced taper than alternative chemical etching methods, the lower degree of taper permitting closer pitch (closer hole-to-hole spacing). This is clearly advantageous, given that microcircuits are becoming progressively smaller and more densely patterned. Through-holes with taper (measured between the substantially straight inner surface of the hole and the axis of the hole) less than 10°, preferably less than 8°, more preferably less than 6°, and especially less than 4° can advantageously be achieved by laser drilling of suitable polymer sheets, and may usefully be incorporated in the invention described herein.
III Punching: The polymeric sheet is placed in a press and metal spikes are forced through it. The method lends itself to any polymer not too brittle, e.g., polysulphone or silicone rubber. Tubular holes 0.1 miilimetre in diameter can be produced in 2 millimetre thick sheets by this method.

The sheets with the patterns of through-holes may be made of high performance polymers able to withstand severe mechanical handling and high temperatures, and may be transparent or translucent. When this is the case the sheets are easy to handle. The transparency or translucency allows for automatic mounting procedures which use light shone through the sheet.

A single conductive through-hole may be provided for each pair of facing connection sites, in which case the diameter of the through-holes is preferably selected to suit the size of the connection sites, or groups of two or more smaller conductive throuhg-holes may be provided to make multiple simultaneous connections between connection sites in each pair.

Uniaxially conductive articles, their use and an example of the invention will now be described with reference to the accompanying drawings, wherein:-
Figure 1 shows schematically an assembly of an uniaxially conductive article between facing sets of connection sites carried on two substrates;
Figures 2a and 2b show schematically overlapping patterns of through-holes any one of which may be aligned with the patterns of connection sites on an appropriate substrate;
Figure 3 shows schematically an arrangement for testing integrated circuit semiconductor chips by means of an uniaxially conductive sheet and a "mirror chip" test circuit;
Figure 4 shows schematically the use of an uniaxially conductive sheet to connect the back of a chip to a heat-sink for thermal control;
Figure 5 shows schematically the use of an uniaxially conductive sheet to connect the front of a chip to a heat-sink for thermal control, possibly together with other connections of the front of the chip to electrical circuitry;
Figure 6 shows schematically a feasible form of uniaxially conductive sheet for thermal and electrical connections of Figure 5;
Figure 7 shows schematically one arrangement for ensuring that an uniaxially conductive sheet avoids unwanted electrical connections with a conductive edge region of the chip resulting from cleavage of the chip from a surface-passivated array of such chips;
Figure 8 shows schematically an alternative arrangement for avoiding unwanted electrical contacts using a surface-passivated circuit board; and
Figure 9 illustrates the application of a further layer of metal to metal conductors projecting from insulating sheet material of the uniaxially conductive article formed according to an embodiment of the invention.

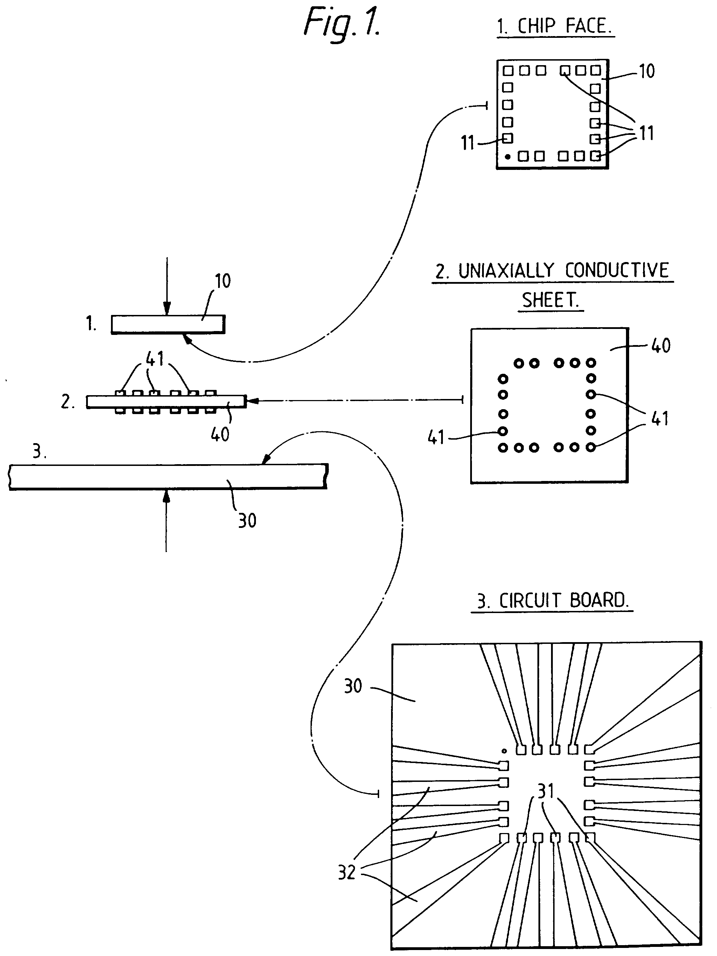

Referring to the drawings, Figure 1 shows schematically an arrangement including a microchip 10 having connector pads 11 on its lower (as illustrated) surface, the pads being shown in the inset plan view of the chip 10. The chip 10 is connected to a fan-out circuit 30, which has contact pads 31 and conductive tracks 32 of known kind for connecting the chip to other test circuitry.

The connection between chip 10 and circuit board 30 is made by uniaxially electrically conductive sheet 40 of the kind hereinbefore described having tubular metal projections 41 in through-holes arranged to correspond with the contact pads of the chip 10 and circuit board 30. Contact between the ends of the metal projections 41 and the respective pads 11 and 31 temporarily or permanently connects the pads 11 of chip 10 to the corresponding pads 31 of the board 30.

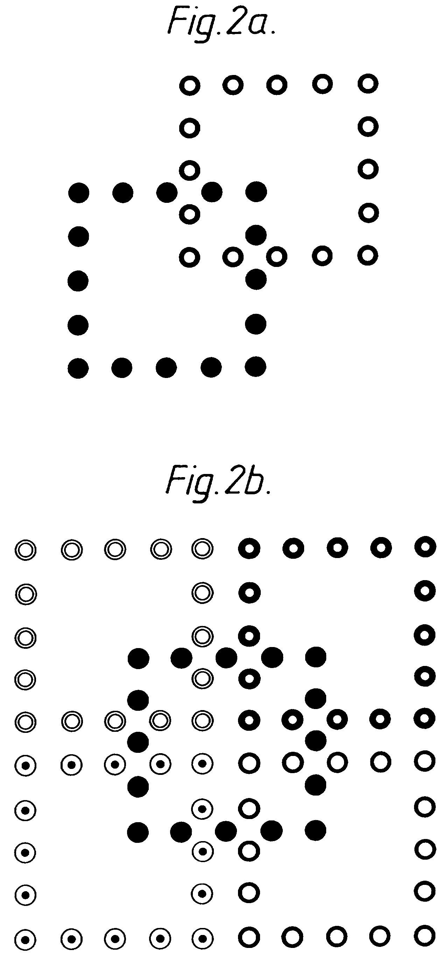

Figure 2a shows one possible pattern for two sets of metal projections 41 to be provided in overlapping arrangement to save space on the sheet substrate of the uniaxially conductive article 40, while Figure 2b shows a possible pattern of five such overlapping sets of projections. Any one of the five sets of projections can be aligned with the connection pads of the chip 10 and board 30 by suitably positioning a sheet 40 having such overlapping patterns. In addition to the space saving, such overlapping patterns may be drilled using fewer "shots" or pulses of the laser in the preferred laser drilling methods, thus significantly extending the working life of the laser.

### CHIP TESTING

Articles manufactured according to this invention may be used in an electrical device or assembly process in which one or more temporary or permanent electrical connections are made by contact with the opposite ends of the electrically conductive material located in the through-holes. Testing of microcircuits before or during assembly into electronic devices may especially benefit from fast, reliable temporary connections between microchip connector pads and the contact pads of a suitable circuit board. Unacceptable chips can thus be rejected before any expensive bonding or packaging operations.

A method of testing an electronic microcircuit chip may comprise
(a) aligning connection sites on the microcircuit chip face-to-face with corresponding connection sites on a test circuit chip,
(b) positioning between the facing chips a uniaxially electrically conductive article comprimising electrically insulating sheet material with at least one through-hole aligned between each pair of facing connection sites, the through-holes containing electrically conductive material which provides an electrically conductive path between, and projects beyond, the main surfaces of the material, and
(c) bringing the respective pairs of connection sites into contact with the electrically conducitve material in the through-holes respectively aligned herewith, thereby temporarily electrically connecting the connection site of the chip to be tested to the connection sites of the test circuit chip.

This "mirror chip" test method has several advantages over known chip testing methods. For example, chips are normally tested at the wafer stage using "probe cards". These are arrays of fine metal probes which are brought into contact with the contact pads on a chip (one probe per pad, so each probe card is specific to the chip design). A com puter drives signals through the probes, and so tests the chip. Probe cards have several disadvantages:-
* the probes damage the pads to the extent that chips can only be probed once;
* probe cards for chips with many pads are very expensive to build;
* high frequency testing using probe cards is difficult because the probes constitute an antenna with uncontrolled impedance, thus causing crosstalk and signal distortion;
* when used for complex chips with many contact pads they are difficult to align, and must be regularly maintained to keep in alignment.
* probe cards are complex and difficult to make for testing chips which have contact pads at other than the periphery.

The uniaxially conductive article manufactured according to this invention has no fragile unsupported pins to become misaligned, and the article can be thrown away if it becomes damaged, since it is relatively inexpensive to replace.

A further advantage is that the uniaxially conductive article can be relatively thin, allowing the chip under test to be brought much closer to the test circuitry e.g. to within 50 - 1000 micrometres or less. This means that the crosstalk and signal distortion is minimised, which is especially advantageous in high speed and/or high frequency chips.

The "mirror chip", that is one with a set of pads that mirror those on the chip under test, is connected to the bulk of the test equipment by other pads, probably around the edge of the mirror chip.

The electrical function of the "mirror chip" would of course depend on the nature of the chip under test. The mirror chip could provide power and ground connections, and output test patterns of digital data, or measure analogue parameters such as capacitance. It may contain A/D convertors or filters, or may simply be "transparent", that is it may pass on undistorted waveforms from the main test equipment. Its function is to output test patterns and gather undistorted information from the chip under test.

For the "mirror chip" testing method now being described, the uniaxial sheet may be constructed with only one through-hole containing the electrically conductive material between each pair of facing connection sites, in which case the size of the through-holes will preferably be chosen to suit the size of the connection sites. Alternatively, there may be two or more smaller through-holes independently containing the electrically conductive material between each pair of connection sites. In either case, the sheet may have substantially no other conductive through-holes, thus providing a single "one-to-one" pattern of conductive paths (one path or one group of paths for each pair of connection sites) as hereinbefore described; or the sheet may have two or more such "one-to-one" patterns interspersed with each other for selective use as also hereinbefore described; or the same sheet may have a multitude of conductive through-holes as described in the aforementioned EP-A-0213774 for randon alignment between the facing pairs of connection sites; always provided that any conductive through-holes not acting between the facing pairs of connection sites do not interfere unacceptably with the chip testing process.

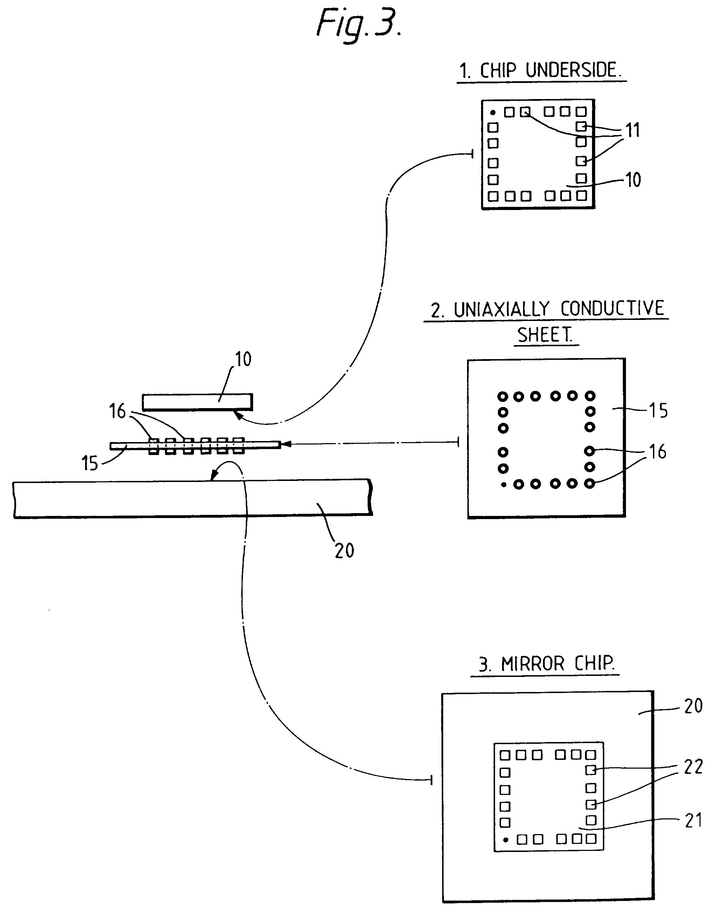

Referring to the drawings, in Figure 3, the chip 10 to be tested has connection pads 11 facing downwards (as illustrated) towards an uniaxially electrically conductive sheet 15 having plated metal tubes 16 positioned in and protruding from an array of through-holes positioned to correspond with the connection pads 11. The sheet 15 is made by the method hereinbefore described. A substrate 20 carries the "mirror chip" 21 with the connection sites 22 corresponding to the metal tubes 16. The chip 10 to be tested may thus be temporarily connected to the "mirror chip" 21 by gently compressing the sheet 15 between the chip 10 and the "mirror chip" 21 which contains test circuitry and is in turn connected to further circuitry (not show) to apply the desired electrical tests. Several different digital and analogue chips may be tested in this way, for example an operational amplifier, and an octal latch, and at high frequencies cross-talk and signal distortion tend to be reduced by the close spacing of the chip and the test circuitry, as aforementioned.

Examination of the chips with optical and electron microscopes after testing by contact with an uniaxially conductive article of the kind described showed that the damage caused to the chip connection sites was very much less than that produced by testing with a conventional probe card.

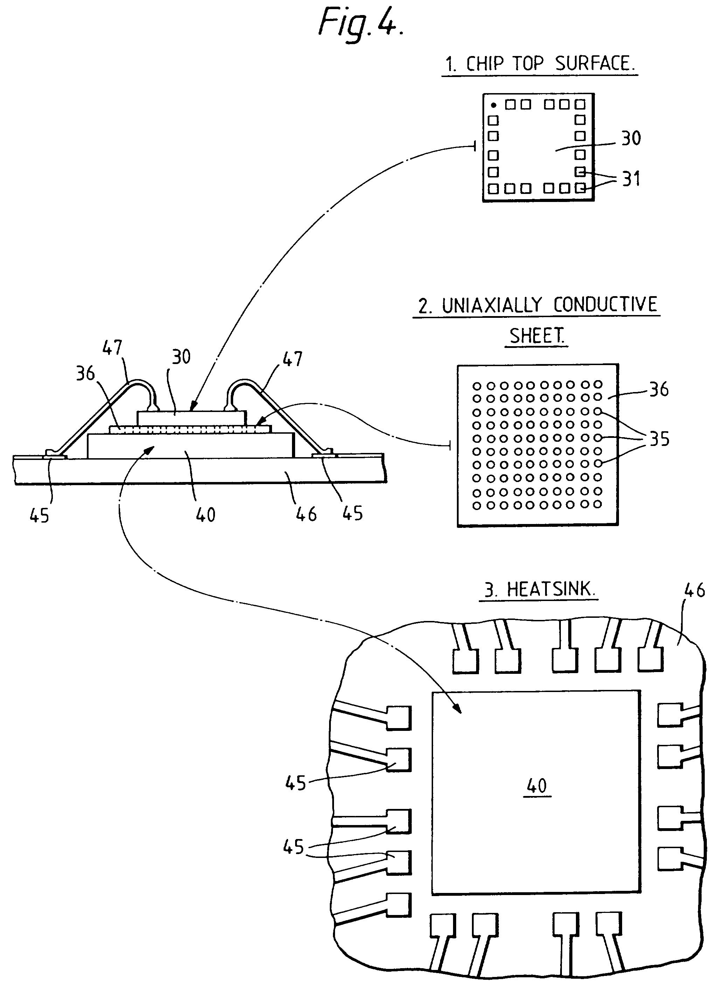

In Figure 4, a chip 30 is shown face-up with its bonding sites 31 wire bonded to the bonding sites 45 of an associated circuit board 46 by gold wires 47. A heat-sink 40 is provided to conduct away heat generated by the chip in operation, and this is thermally connected to the back of the chip 30 by contact with the projecting metal tubes 35 of an uniaxially conductive sheet 36 of the kind generally described hereinbefore. Although a regular array of metal tubes 35 is indicated in this schematic drawing, non-symetrical and/or irregular spacing of the tubes may also be used to control the pattern of heat dissipation as required. For example, greater concentration of the metal tubes could be provided to connect to a particularly hot area of a given chip.

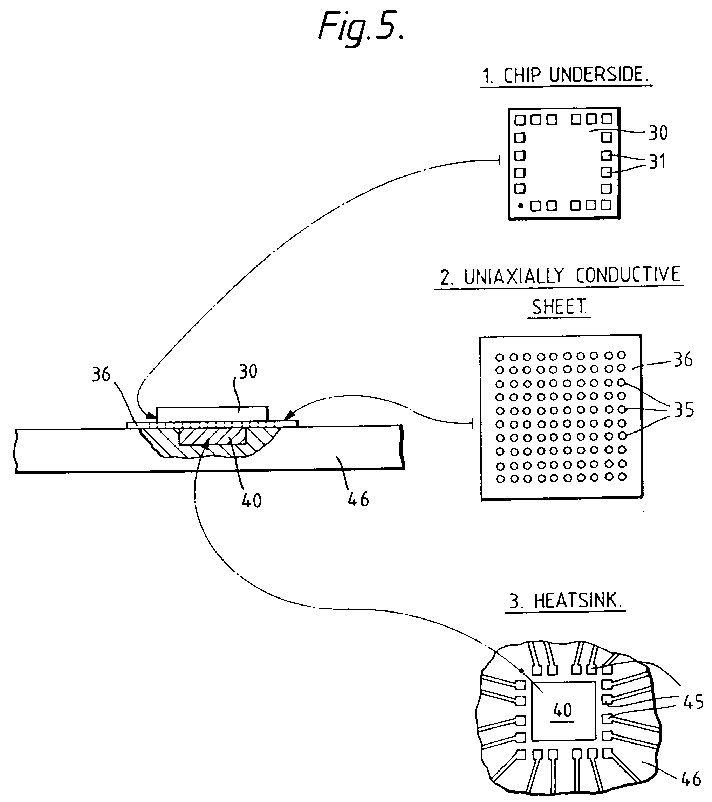

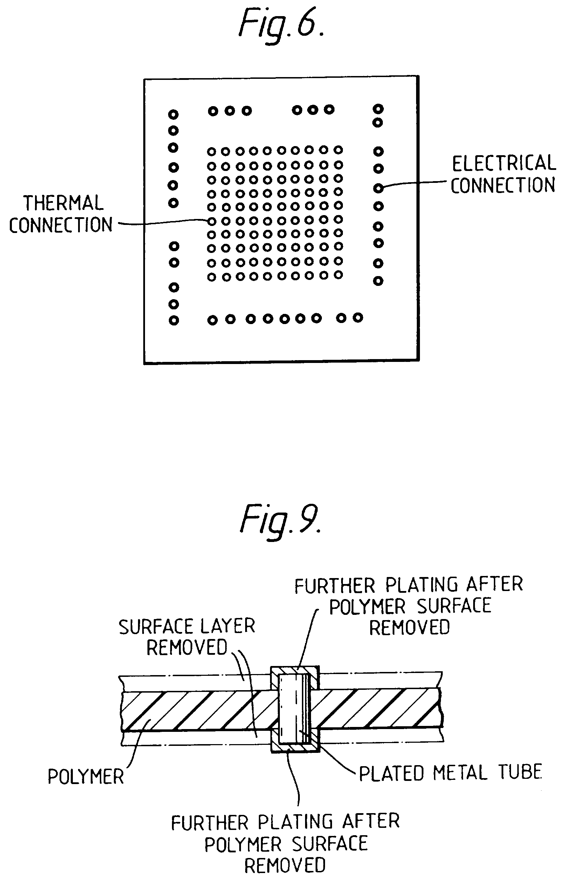

Figure 5 shows an alternative heat-sink arrangement, in which chip 30 is bonded face-down not only to the heat-sink 40, but also to connection sites 45 of the substrate 46. For this purpose, the uniaxially conductive sheet 36 has metal-plated through-holes 35 aligned between the bonding sites 31 of the chip 30 and the bonding sites 45 of the substrate 46 in addition to the plated holes which connect the passivated areas of the chip 30 to the heat-sink 40. One pattern of through-holes for this purpose is illustrated in Figure 6.

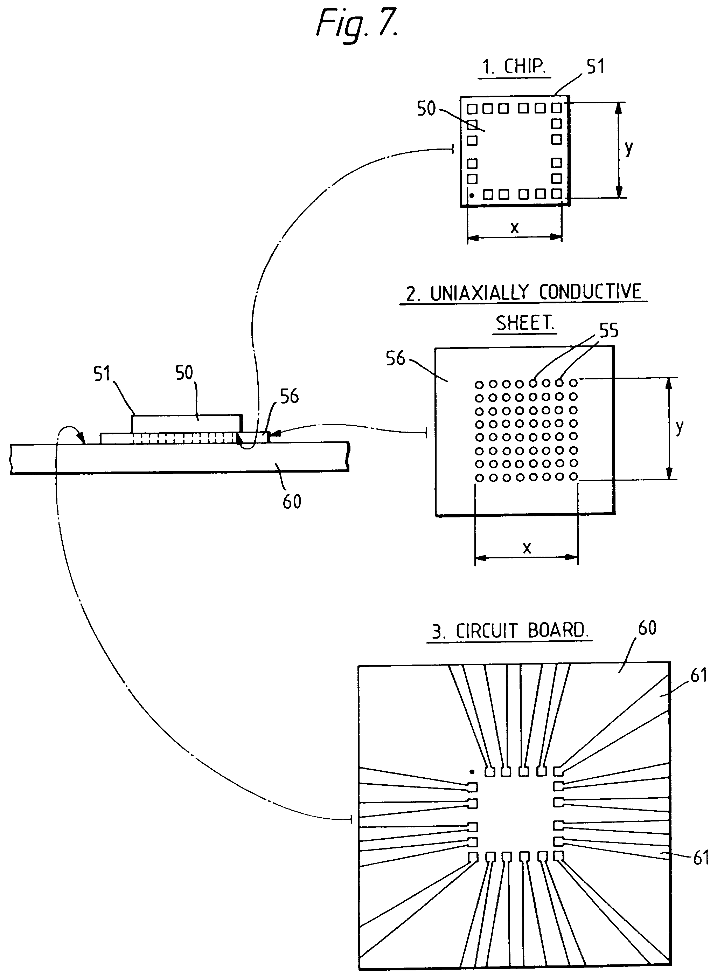

Figure 7 illustrates the connection of a chip 50 to a circuit-board 60, where the chip has an unpassivated edge region 51 resulting from cleaving of the chip from a wafer of such chips in known manner. In this arrangement, the multitude of metal-plated through-holes 55 of a uniaxially conductive sheet 56 made by the aforementioned methods is confined to an area XY which is arranged to avoid contact of the projecting metal tubes with the electrically conductive chip edge 51. In this way, undesired short-circuits between the conductive tracks 61 on substrate 60 are avoided.

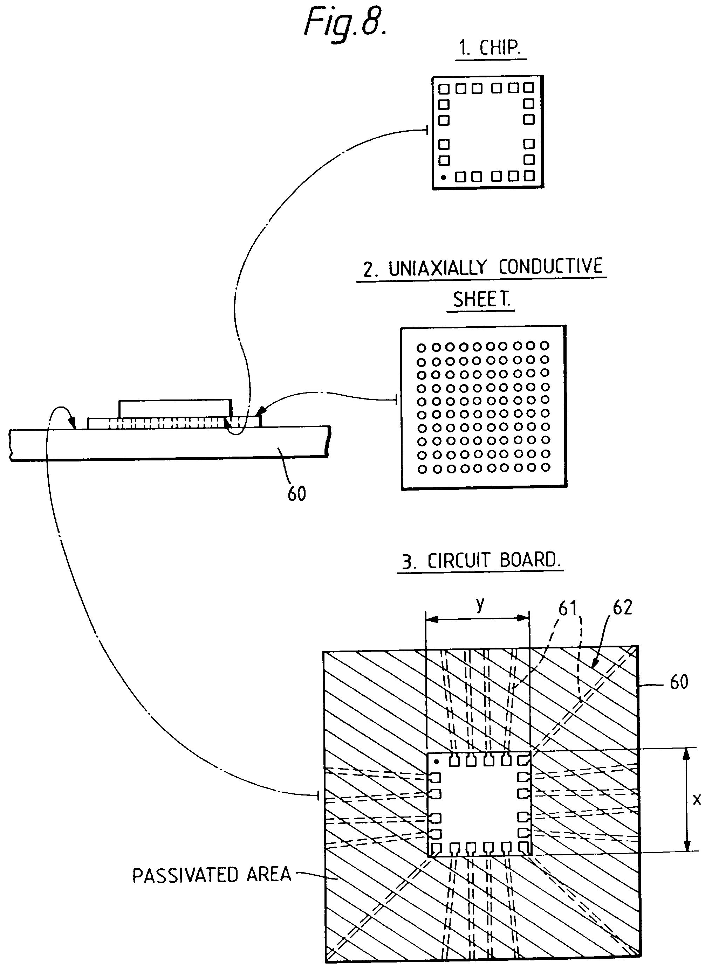

Figure 8 shows an alternative to the arrangement of figure 7, in which the multitude of plated holes no longer needs to be confined to area XY as a passivating surface 62 is provided on the substrate 60 which overlies and passivates all of the conductive tracks except within the area corresponding to area XY of the chip.

### OVERPLATING

Figure 9 illustrates an inventive aspect in the application of a further layer of metal, e.g. gold plating, after removal of one or more surface layers of polymer to produce projecting metal conductors in the holes of the uniaxially conductive articles. The further plating acts as a collar to help retain the projecting metal , (e.g. plated tubes) in the holes. The resulting uniaxially electrically conductive article comprises electrically insulating sheet material with through-holes individually containing the electrically conductive material with overplated projecting ends.

## Claims

1. A method of manufacturing an uniaxially electrically conductive article comprising electrically insulating sheet material with through-holes, the method including forming plated metal electrical conductors contained individually in the through-holes and having ends projecting from the sheet material, and forming a plating of a further layer of metal on the projecting ends, which plating acts as a collar to help retain each plated metal conductor in the respective through-hole, each conductor providing an electrically conductive path between the main surfaces of the sheet material.

2. A method according to claim 1 wherein electrically insulating material is removed from at least one of the main surfaces of the sheet material to expose portions of the electrically conductive material originally within the through-holes, prior to overplating of the ends.

3. A method according to any preceding claim wherein at least some of the through-holes are not more than 200 micrometres in diameter.

4. A method according to any preceding claim wherein the said through-holes have been made by laser drilling, preferably by U.V. laser ablation.

5. A method according to any preceding claim in which the plated metal electrical conductors are formed with ends projecting from both the main surfaces of the sheet material and the plating of the further layer of metal is formed adjacent to both the main surfaces of the sheet material.

## Patentansprüche

1. Verfahren zum Herstellen eines uniaxial elektrisch leitfähigen Gegenstands, der elektrisch isolierendes Flächenkörpermaterial mit Durchgangsbohrungen aufweist, wobei das Verfahren folgendes aufweist: Ausbilden von metallisierten elektrischen Leitern, die jeweils einzeln in den Durchgangsbohrungen enthalten sind und Enden haben, die von dem Flächenkörpermaterial vorspringen, und Bilden einer Metallisierung aus einer weiteren Metallschicht auf den vorspringenden Enden, wobei diese Metallisierung als ein Kragen wirkt, um zum Festlegen jedes metallisierten Leiters in der jeweiligen Durchgangsbohrung beizutragen, wobei jeder Leiter eine elektrisch leitfähige Bahn zwischen den Hauptflächen des Flächenkörpermaterials bildet.

2. Verfahren nach Anspruch 1, wobei elektrisch isolierendes Material von wenigstens einer der Hauptflächen des Flächenkörpermaterials entfernt wird, um Bereiche des ursprünglich in den Durchgangsbohrungen vorhandenen elektrisch leitfähigen Mateirals freizulegen, bevor die Enden übermetallisiert werden.

3. Verfahren nach einem der vorhergehenden Ansprüche, wobei wenigstens einige der Durchgangsbohrungen einen Durchmesser von nicht mehr als 200 µm haben.

4. Verfahren nach einem der vorhergehenden Ansprüche, wobei die Durchgangsbohrungen durch Laserbohren, bevorzugt durch UV-Laserablation hergestellt worden sind.

5. Verfahren nach einem der vorhergehenden Ansprüche, wobei die metallisierten elektrischen Leiter mit von den beiden Hauptflächen des Flächenkörpermaterials vorstehenden Enden gebildet werden und die weitere Metallisierungsschicht benachbart den beiden Hauptflächen des Flächenkörpermaterials gebildet wird.

## Revendications

1. Procédé de fabrication d'un article électroconducteur uni-axial, comprenant un matériau en feuille isolant de l'électricité, présentant des trous traversants, le procédé comprenant la formation de conducteurs électriques en métal, plaqués, contenus individuellement dans les trous traversants et ayant des extrémités faisant saillie depuis le matériau en feuille, et la réalisation d'un plaquage d'une autre couche de métal sur les extrémités en saillie, ledit plaquage agissant comme un collier, pour aider à retenir chaque conducteur métallique plaqué dans le trou traversant respectif, chaque conducteur créant un chemin électroconducteur entre les surfaces principales du matériau en feuille.

2. Procédé selon la revendication 1, dans lequel le matériau isolant de l'électricité est enlevé d'au moins l'une des surfaces principales du matériau en feuille, afin d'exposer des parties du matériau électroconducteur se trouvant à l'origine à l'intérieur de trous traversants, avant d'effectuer le sur-plaquage des extrémités.

3. Procédé selon l'une quelconque des revendications précédentes dans lequel au moins certains des trous traversants ont un diamètre ne dépassant pas 200 micromètres.

4. Procédé selon l'une quelconque des revendications précédentes, dans lequel lesdits trous traversants sont réalisés par perçage au laser, de préférence par ablation au laser U.V.

5. Procédé selon l'une quelconque des revendications précédentes dans lequel les conducteurs électriques en métal plaqué sont formés avec des extrémités faisant saillie des deux surfaces principales du matériau en feuille et le plaquage de la couche supplémentaire de métal étant réalisé adjacent aux deux surfaces principales du matériau en feuille.
